Europäisches Patentamt

European Patent Office

Office européen des brevets

(19)

(11) Publication number: **0 023 534**
A2

(12) **EUROPEAN PATENT APPLICATION**

(21) Application number: **80101969.6**

(22) Date of filing: **11.04.80**

(51) Int. Cl.³: **H 01 L 21/60**, H 01 L 23/48

(30) Priority: **06.08.79 US 63827**

(43) Date of publication of application: **11.02.81**
Bulletin 81/6

(84) Designated Contracting States: **CH DE FR GB LI NL**

(71) Applicant: **Teccor Electronics, Inc., 1101 Pamela Drive, Euless, Texas 76039 (US)**

(72) Inventor: **McCoy, Dennis M., 8862 Larchwood, Dallas, Texas 75238 (US)**

(74) Representative: **Patentanwälte Dipl.-Ing. A. Grünecker, Dr.-Ing. H. Kinkeldey, Dr.-Ing. W. Stockmair,, Dr. rer. nat. K. Schumann, Dipl.-Ing. P.H. Jakob, Dr. rer. nat. G. Bezold Maximilianstrasse 43, D-8000 München 22 (DE)**

(54) Semiconductor device mounting structure and method of mounting.

(57) An improved semiconductor chip mounting structure and method by which a semiconductor chip is attached to a substrate by soldering using mass production techniques while excess solder is draw off to prevent shorting of the device to the substrate. At least one capillary structure is provided passing through the substrate in the region under the semiconductor chip so that excess solder between the chip and substrate are drawn off into the capillary aperture instead of forming an excessively large fillet and possibly shorting out the device. In a preferred form the capillary means is a small diameter hole punched through the substrate during lead frame fabrication.

1

## SEMICONDUCTOR DEVICE WITH IMPROVED CHIP MOUNTING

The present invention relates to semiconductor devices and more particularly to an improved semiconductor device mounting structure and method of mounting a semiconductor chip on a substrate by soldering while excess solder is drawn away from the chip to prevent shorting to exposed semiconductor material on the edges of the chip.

A wide variety of semiconductor component chip mounting structures have been developed and used in efforts to provide reliable and yet inexpensive semiconductor components. The use of molded plastic packages and copper lead frames with components soldered to the lead frames has in general proven to be one of the most effective packaging techniques. In semiconductor assemblies of this type, lead frames are usually punched out of long strips and include both a substrate for supporting a component chip and leads for making additional connections to the device. A solder coating is usually provided on the lead frame and/or on the surfaces of the component chip to which electrical contact can be made.

The chips and lead frame are assembled together and held in position by appropriate boats or other fixtures while the entire assembly is heated sufficiently to reflow the solder and make all connections simultaneously. In general some pressure must be applied to the leads on a top surface of a component chip to force the leads against the chip and the chip against a substrate to insure that proper contact is made when solder is reflowed.

One problem has been discovered in this type of assembly. While the prewetting of component chips with solder has been found to have many advantages when compared to the use of solder preforms, it has still proven very difficult to provide precisely controlled solder thicknesses on the chips. Very little solder is actually required to make the necessary connections. During the assembly process the excess solder is normally squeezed out of the space between the chip and the substrate to form a fillet surrounding the chip. It has been found this fillet may often be sufficiently large to electrically contact exposed silicon on the edges of the chip and to thereby short out the device and make it useless. The fillet can conceivably be large enough to make contact with the leads which approach the top surface of the chip at a low angle. Efforts have been made to cause the solder to spread across the surface of the substrate by forming a crosshatch pattern of shallow grooves in the surface to which the chip is bonded and usually extending away from the edges of the chip. In practice it has been found difficult to control the depth and shape of the stamped grooves so that the ability to draw solder away from the chip has varied widely under production conditions. In addition, such a structure greatly reduces the surface area to which the chip makes good thermal contact and thereby degrades the performance of the device.

## SUMMARY OF THE INVENTION

Accordingly, an object of the present invention is to provide a semiconductor chip mounting structure having a reproducable means for withdrawing excess solder from the junction of a semiconductor chip and substrate.

Another object of the present invention is to provide an improved semiconductor device mounting structure providing good thermal contact between the chip and substrate.

Another object of the present invention is to provide an improved method of assembling semiconductor chips to substrates by soldering which allows substantial pressure to be applied in holding the chip in position on the substrate without forming excessively large solder fillets.

A semiconductor device according to the present invention includes a solderable substrate having capillary means passing through the substrate with one end thereof positioned under a semiconductor chip. An improved assembly technique includes urging the semiconductor chip against the substrate with sufficient force to displace excess solder from between the chip and substrate with the excess being drawn away into the capillary means.

BRIEF DESCRIPTION OF THE DRAWINGS

The present invention may be better understood by reading the following detailed description of the preferred embodiments with reference to the accompanying drawings wherein:

FIGURE 1 is a cross sectional view of a prior art semiconductor component mounting structure illustrating the problem of excess solder;

FIGURES 2 and 3 are cross sectional illustrations of a chip mounting structure according to the present invention; and

FIGURES 4 and 5 are cross sectional illustrations of processing steps in preparation of a semiconductor chip for use in the chip mounting structure of the present invention.

DESCRIPTION OF THE PREFERRED EMBODIMENTS

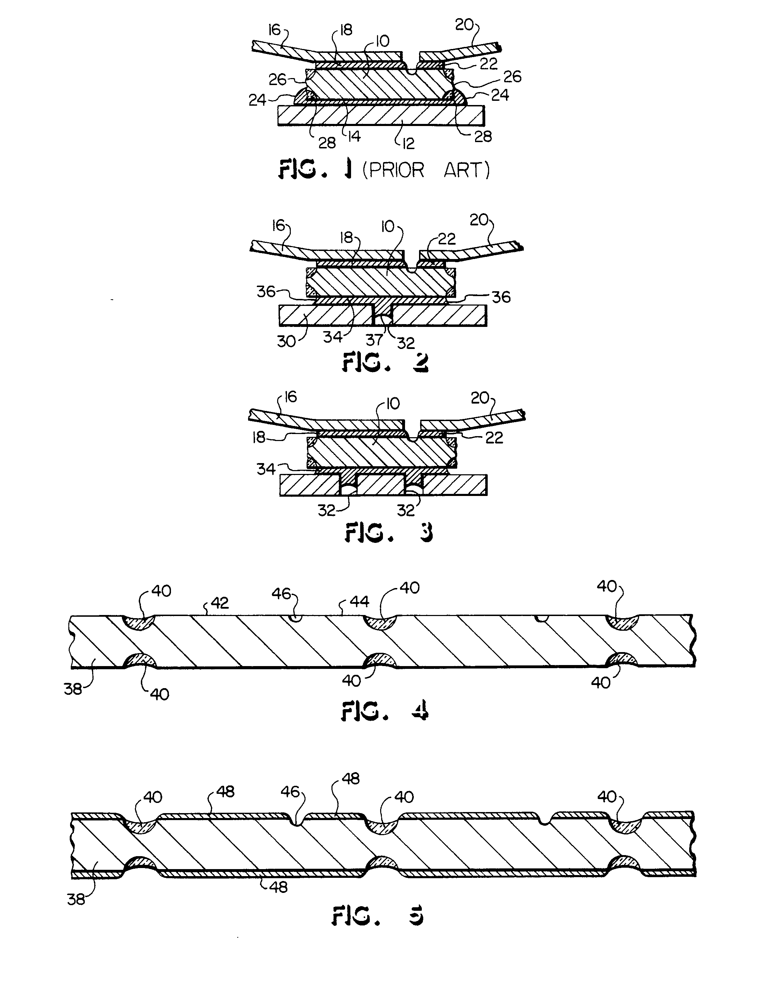

With reference now to Figure 1, the basic prior art structure and problems associated therewith will be described. In Figure 1, a semiconductor component chip 10 is shown attached to a solderable substrate 12. Chip 10 may be a conventional triac device having an anode which is electrically connected to solderable substrate 12 by means of a solder layer 14. Triac 10 further has a cathode region soldered to a cathode lead 16 by a solder layer 18. Triac 10 additionally has a gate region connected to a gate lead 20 by a solder layer 22. Substrate 12 and leads 16 and 20 typically are stamped from copper and initially may be all part of a single lead frame. Solder layers 14, 18 and 22 may be supplied by use of solder preforms but preferably are supplied by prewetting the appropriate surfaces of the chip 10 and the substrate 12 and leads 16 and 20. During mounting of the semiconductor chip 10, the substrate 12, chip 10 and leads 16 and 20 are positioned relative to each other as shown in Figure 1. Some minimal amount of pressure is supplied as by placing a weight on top of the structure as the entire unit is heated sufficiently to reflow the solder and form the solder connections 14, 18 and 22. Quite often excess solder occurs in the solder layer 14 and flows out around chip 10 to form fillets 24 which tend to wet sides 26 of chip 10. In one form of chip 10, corners 28 are glass-passivated and thus resist wetting and electrical contact with the solder fillets 24. It is not desirable to have fillet 24 in contact with the outer edges of the chip, even in the glass regions 28 since minute cracks can be formed therein and provide a path for a short circuit to the chip. The solder fillets 24 are often sufficiently large to bridge the lower glass regions 28 and contact exposed silicon on the edges 26 of chip 10, short circuiting active regions and ruining the device.

With reference now to Figure 2, an improved semiconductor chip mounting assembly according to the present invention is illustrated. In this assembly, the chip 10, leads 16 and 20 and solder layers 18 and 22 may be identical to those illustrated in Figure 1. An improved solderable substrate structure 30 is provided for supporting chip 10 and preventing formation of fillets 24. In particular, an aperture 32 is provided extending through substrate 30 from its upper to lower surfaces and positioned at the center of chip 10. As illustrated, solder layer 34 bonds chip 10 to substrate 30 and a portion of the solder 34 extends down into aperture 32. The solder layer 34 between chip 10 and substrate 30 is depicted as somewhat exaggerated in thickness compared to actual scale so that its position relative to the edges of chip 10 may be better illustrated. That is, instead of a fillet 24 (as shown in Figure 1) extending substantially outward from the edge of chip 10, the solder layer 34 ends in a very small meniscus 36 at the edge of chip 10 to which it is drawn by capillary action. The excess solder which would otherwise form a fillet 24 is drawn in to aperture 32 to form a meniscus 37 therein. In a preferred assembly method, considerable force is applied by means of leads 16 and 20 to the top surface of chip 10 to force it against the substrate 30 during the solder reflow operation to minimize the thickness of the solder layers 13, 22 and 34. The aperture 32 has proven quite efficient at drawing away substantially all excess solder from layer 34.

The Figure 3 embodiment of the present invention is essentially the same as that of Figure 2 except that two of the apertures 32 are provided for drawing excess solder from the solder layer 34. The plurality of apertures 32 can serve various functions. The most apparent advantage of a plurality of apertures is larger capacity for drawing excess solder from the layer 34. But since the capillary attraction of the apertures 32 for the solder is a function of aperture diameter it may prove desirable in some cases to provide a number of small apertures 32 rather than a single larger aperture having the same total volume. The higher capillary action of the smaller apertures may provide a stronger force to withdraw excess solder and thereby speed up and otherwise improve the assembly process.

In both the Figure 2 and Figure 3 arrangements it will be noted that the chip 10 contacts and is supported by a substantially flat upper surface of the substrate 30 and thereby makes good thermal contact to the substrate. The prior art surface groove structures cannot provide this good thermal contact since a considerable amount of the surface area is used up in formation of grooves to absorb the excess solder and draw it away from the chip 10. The present structure employing apertures 32 passing completely through the substrate 30 provides the maximum solder capacity with minimum use of substrate surface area. Apertures 32 are preferably cylindrical since this is the simplest shape which may be punched through the substrate. It is a fairly simple matter to punch the apertures 32 as part of the stamping operation in which lead frames are formed but they may be

punched as a separate step if desired. Such stamping or punching processes can be closely controlled so that dimensions of apertures 32 are very reproducable.

With reference now to Figures 4 and 5, the preparation of semiconductor chips used in the present chip mounting structure will be described so that the method of assembly can be better understood. In both figures a section of a silicon slice or wafer 38 is illustrated having a pair of appropriately doped silicon semiconductor components defined between glass filled moats 40. A cathode region 42 of each device is separated from a gate region 44 by a smaller glass region 46. Those skilled in the art will appreciate that there are a plurality of conventionally doped P and N type regions within the wafer 38 which are arranged to provide the desired semiconductor devices, such as triacs in the present example. A wafer which has been thus prepared and contains a large number of such triac devices is then dipped in molten solder. The result of such dipping is illustrated in Figure 5 where the molten solder adheres to all the semiconductor surfaces of both sides of the wafer thereby forming mounds 48 separated by the glass filled moats 40 and glass regions 46. After the devices have thus been prewet with solder, the wafer is scribed along the glass filled moats 40 with conventional laser scribing equipment and the wafer is broken into individual chips 10 as illustrated in Figures 2 and 3.

It can be seen that this method of providing the necessary solder for the chip mounting assembly has several advantages over other techniques, such as the technique of using solder preforms. The prewetting is performed on an entire slice of devices at one time thereby treating hundreds of devices simultaneously. The layer of solder 48 may be thinner than could be provided by any practical solder preform. No additional elements such as the preform must be assembled prior to the final soldering operation. But, even though the solder layers 48 are much thinner than could be provided with preforms, they still have a generally excess amount of solder than is actually required because the solder layer thickness cannot be controlled as accurately as would be desired. It is for this reason that the assembly of the present invention illustrated in Figures 2 and 3 is provided.

In a preferred method of assembly according to the present invention the substrate 30 and leads 16 and 20 are part of a single lead frame containing a large number of substrates and leads. Such lead frames are typically stamped from sheet copper and apertures 32 are punched through substrate 30 at the mounting location for chip 10 at the time of fabrication. The leads 16 and 20 are bent over substrate 30 in such a way to act as spring arms holding the ends of leads 16 and 20 against substrate 30. Chips 10 which have been separated from the wafer 28 are positioned on substrate 30 while arms 16 and 20 are temporarily lifted. Once chip 10 is in position, the arms 16 and 20 are released to contact chip 10 and hold it in the desired position. In this way no separate jig or other holding fixture or weights are required to hold the various parts together during solder reflow. The entire assembly is then heated sufficiently to reflow the solder 48 on chip 10 to form the connecting layers 18, 22 and 34 as illustrated in Figures 2 and 3. When the solder has cooled, a conventional molded plastic housing is formed around the assembly of Figures 2 and 3 and a lead frame is cut to provide three separate contacts to the chip 10.

A test comparing the yields of assemblies like that shown in Figure 1 with the assemblies of the present invention illustrated in Figure 2 has been performed. Lead frames were chosen from the same lot with one batch having additional aperture 32 punched through the chip mounting area. The lead frames were of .02 inch thick copper and those used for the Figure 2 type assembly were provided with a cylindrical aperture of .02 inches in diameter. Triac chips measuring .125 inches square were selected from the same lot for both types of assemblies. Other processing parameters were held as contant as possible between the two groups. After assembly, only 69% of the devices contructed according to the Figure 1 prior art arrangement tested good. In contrast 97% of the devices constructed according to the Figure 2 embodiment of the present invention tested good. Visual observation of the aperture 32 in the group constructed according to the Figure 2 embodiment showed considerable variation in the amount of solder within the apertures 32. This variation indicated the differences in the amount of solder provided on the prewet chips 10 and also indicated that the apertures 32 were essentially effective in drawing away the excess in all cases. Additionally, a few devices were noted having solder protruding from the lower surface of substrate 30 to form a noticeable solder bump. The presence of such solder bumps indicates that the solder withdrawing capacity of apertures 32 is even greater than was anticipated.

While the present invention has been illustrated and described in terms of specific apparatus and methods of assembly, it is apparent that various modifications and changes can be made. For example while the present invention has been described only with respect to triac devices it is quite apparent that the chip mounting structure is equally suitable for any of various types of semiconductor chips which require soldering to a suitable substrate, such as diodes and transistors, for example. In addition while the substrate 30 has been described as a solid copper substrate, other substrates with a solderable surface, such as metalized alumina, could also be used. Other modifications and changes may also be made within the scope of the present invention as defined by the appended claims.

CLAIMS

1. In a semiconductor assembly of the type in which a semiconductor component chip is attached to a supporting substrate by soldering to a metallic surface of said substrate, the improvement comprising capillary means formed through said substrate and in communication with said metallic surface for drawing away excess solder.

2. An improved semiconductor assembly according to Claim 1 wherein said capillary means comprises at least one aperture passing through said substrate with one end of said aperture adjacent a surface of said component chip.

3. An improved semiconductor assembly according to Claim 2 wherein said aperture is cylindrical and has a diameter substantially smaller than an edge dimension of said chip.

4. A packaged semiconductor device comprising a semiconductor component chip attached to a metallic substrate by soldering and one or more leads attached to active regions of said component chip by soldering wherein said metallic substrate includes at least one aperture, passing through said substrate, substantially smaller than said component chip, with one end of said aperture adjacent a lower surface of said component chip to provide means for removing excess solder from the junction of said component chip and substrate.

5. A semiconductor device according to Claim 4 wherein said at least one aperture is cylindrical.

6. In the process of packaging semiconductor component chips of the type in which a component chip is attached to a substrate by soldering, the improvement comprising the use of capillary means formed through said substrate adjacent said component chip for drawing away excess solder during the soldering operation .

7. The improved packaging process according to Claim 6 wherein said capillary means comprises a cylindrical aperture formed through said substrate having a diameter substantially smaller than the maximum dimension of said component chip.

8. A process for manufacturing a packaged semiconductor device comprising:

forming a plurality of semiconductor components on a first surface of a slice of semiconductor material,

wetting a second surface of said slice with molten solder and cooling said slice to solidify said solder,

breaking said slice into a plurality of rectangular chips, each carrying one or more of said components,

forming capillary means extending through a solderable substrate adapted for supporting a chip,

positioning a chip on said substrate with its second surface overlying at least a portion of said capillary means,

heating said chip and substrate to reflow the solder carried on said chip second surface and bond said chip to said substrate with excess solder drawn off by said capillary means.

9. In a process of packaging a semiconductor component chip of the type having layers of solder on a mounting surface and at least one contact area of said chip, the steps of:

stamping from sheet metal a lead frame having a substrate for receiving said mounting surface of said chip, and at least one lead for bonding to said at least one contact area,

forming an aperture through said substrate,

forming said at least one lead to overlie and contact said substrate,

positioning said chip between said at least one lead and said substrate, whereby spring tension of said at least one lead holds said chip in place,

heating said lead frame and chip until said solder melts,

cooling said lead frame and chip to solidify said solder and bond said chip to said substrate and said at least one lead to said at least one contact area.

0023534

10. A process of packaging a semiconductor component chip according to Claim 9 wherein:

said aperture formed through said substrate is cylindrical and has a diameter substantially less than an edge dimension of said chip component.

0023534

1 / 1

FIG. 1 (PRIOR ART)

FIG. 2

FIG. 3

FIG. 4

FIG. 5